# EUROPEAN PATENT SPECIFICATION

(11) **EP 1 675 288 B1**
(45) Date of publication and mention of the grant of the patent: **05.06.2013**
(21) Application number: 05397028.1
(22) Date of filing: 23.12.2005
(51) Int. Cl.: H04H 20/79, H04H 60/96, H04N 21/61, H03H 7/46

(54) **An arrangement for the transmission of a data signal in a cable television network**
ANORDNUNG ZUR ÜBERTRAGUNG EINES DATENSIGNALS IN EINEM KABELFERNSEHNETZWERK
DISPOSITIF POUR TRANSMETTRE UN SIGNAL DE DONNEES DANS UN RESEAU DE TELEVISION PAR CABLE

(30) Priority: 23.12.2004 FI 20045502
(43) Date of publication of application: 28.06.2006
(73) Proprietor: Teleste Oyj, 20660 Littoinen (FI)
(72) Inventor: Heikkonen, Timo, 20540 Turku (FI); Kangas, Juha, 21120 Raisio (FI)
(74) Representative: Pursiainen, Timo Pekka

(56) References cited:
- EP-A2- 1 383 329
- US-A- 5 390 337
- US-A- 6 049 693
- US-A1- 2004 230 998
- US-B1- 6 481 013

## Description

### Field of the invention

The invention relates to an arrangement for transmitting a data signal in a cable television network, particularly when using a baseband data signal.

### Background of the invention

As the use of the Internet is becoming more and more common, the demand of home Internet connections is constantly increasing. Conventional telephone modem connections are relatively slow, due to their narrow bandwidth, and they typically engage the telephone line for the time of the Internet connection. A higher transfer rate is available by means of various xDSL and cable modem subscriber lines. Particularly in areas in which a television signal is led to homes via a cable network, the cable network provides an existing transmission path for the transmission of data signals as well.

In a cable television system (CATV, Community Antenna Television) of the DOCSIS (Data-Over-Cable Service Interface Specifications) type, the data signal is modulated to its specific frequency (channel) in the same way as TV signals, wherein the signals can be transmitted in the same cable and be separated from each other in the receiving set. Households will need a particular cable modem (CM) for setting up a data connection to a computer. A disadvantage for homes is that cable modems are relatively expensive. Cable network operators have the problem that expensive network equipment CMTS (Cable Modem Termination System) used for cable modem connections is only capable of offering a limited number of connections. Furthermore, the cable modem connection has the disadvantage that the network is a trunked network, in which the available transmission capacity (for example, the transmission capacity of one branch of the CATV network) is divided between all the subscriber lines used at the same time, wherein the transmission capacity available for a single home may be small.

To avoid these disadvantages, a solution has been developed that is described in more detail in patent application EP 1 099 349. EP 1 099 349 describes a method and a device for transmitting an Ethernet signal in a full duplex manner to a subscriber line of a cable network. Ethernet signals transmitted in two directions in two separate cables are combined by a combining device to form a signal to be transferred in two directions in a single cable, and they are finally combined by a diplexer with a conventional CATV signal. The formed combined signal can be transmitted in the subscriber line of the CATV network. At the receiving end (in the home connection) of the combined signal, respectively, the Ethernet signal and the CATV signal are separated from the combined signal by filters. The transmission directions of the duplex Ethernet signal are separated by means of a splitting device, and the transmission and reception signals are conveyed by separate cables to the computer, typically via a network adapter connection. The CATV signal is led to the television in the normal way.

The purpose of the patent application EP 1 099 349 is to provide inexpensive means for using the CATV network for the transmission of both a CATV signal and, for example, an Ethernet signal to be led to a computer without a cable modem. As the transmission of the baseband data signal does not require modulation/demodulation, it is possible to use passive components for combining and separating the CATV signal and the baseband Ethernet signal.

In practice, the above-described arrangement cannot be used as such for the transmission of the Ethernet signal, because the presented structure causes too strong an attenuation for using the network adapters of the computer without problems. In the Ethernet standard IEEE 802.3, a maximum value of 11.5 dB is set for the attenuation at the frequency of 10 MHz, but this value is exceeded in the above-described cable network arrangement. Yet a more difficult problem is caused by the lower frequencies of the transmission band, because the lower frequencies are attenuated more in the presented coaxial cable network arrangement than in a twin cable connection. The greatest partial component of the attenuation comes from the splitting/combining devices, in which the signals propagating in two different directions are connected to a single line and, respectively, separated into the transmission and receiving branches at the other end. Thus, with the network arrangement of prior art, it is not possible to achieve the desired attenuation values on the whole transmission band, which causes signal distortion, further reducing the possibility to set up a link in a reliable way. As it is also known that at least some network adapters of computers lose the link even at lower attenuation values, there is a need for an arrangement implementing a lower attenuation.

### Brief description of the invention

Now, an improved arrangement has been developed to reduce the above-mentioned problems. As different aspects of the invention, we present a communication system, a network element and a branch circuit, which are characterized in what will be presented in the independent claims. The dependent claims disclose advantageous embodiments of the invention.

The basis of the invention is that in the above-presented network arrangement, a branch circuit is used which has been coupled in an integrated manner between the node point of a data network comprising a receiving port with a high impedance, and a combiner combining a cable television signal and a baseband duplex data signal, for separating the data signal to be transmitted and the data signal to be received as separate branches for said node point, in which branch circuit the impedances of said branches are arranged to be substantially unequal so that the impedance of the receiving branch is arranged to be higher, to consist substantially of the impedance of said receiving port, and in which receiving branch a voltage amplification is arranged by means of a transformer coupling in the receiving branch and the impedance of said receiving branch, to compensate for attenuation in the receiving branch.

In other words, one starting point of the invention is to combine an Ethernet multi-port switch and the above-described branch circuit and filter arrangement, which are thus integrated to form a single device unit. It is thus possible to eliminate some components of prior art that cause attenuation and, at the same time, to utilize the high impedance of the receiving port of the Ethernet multi-port switch to produce voltage amplification.

The arrangement of the invention has the advantage that by suitable dimensioning of the components of the branch circuit arrangement, it is possible to reduce the loss of the link segment by more than 2 dB, wherein the value obtained as the total loss of the whole link segment is about 9.5 dB at the frequency of 10 MHz. Furthermore, the attenuation of the link is reduced by more than 2 dB up in the whole frequency band available, wherein for example at the frequency of about 5 MHz, the attenuation is substantially the same as in typical Ethernet twin cables. Thus, in practice, all the network adapters on the market are capable of maintaining a data transmission connection with such a link segment.

### Brief description of the drawings

The invention will now be described in more detail in connection with preferred embodiments with reference to the appended drawings, in which:
Fig. 1 shows a network arrangement of prior art for the transmission of a CATV signal and a baseband duplex data signal;
Fig. 2 is a chart showing the attenuation response of a network arrangement of prior art as a function of the frequency;
Fig. 3 is a block chart showing an advantageous embodiment of the invention;
Fig. 4 is a reduced block chart showing an advantageous embodiment of the invention; and
Fig.5 is a reduced circuit diagram showing an advantageous embodiment of the invention.

### Detailed description of the invention

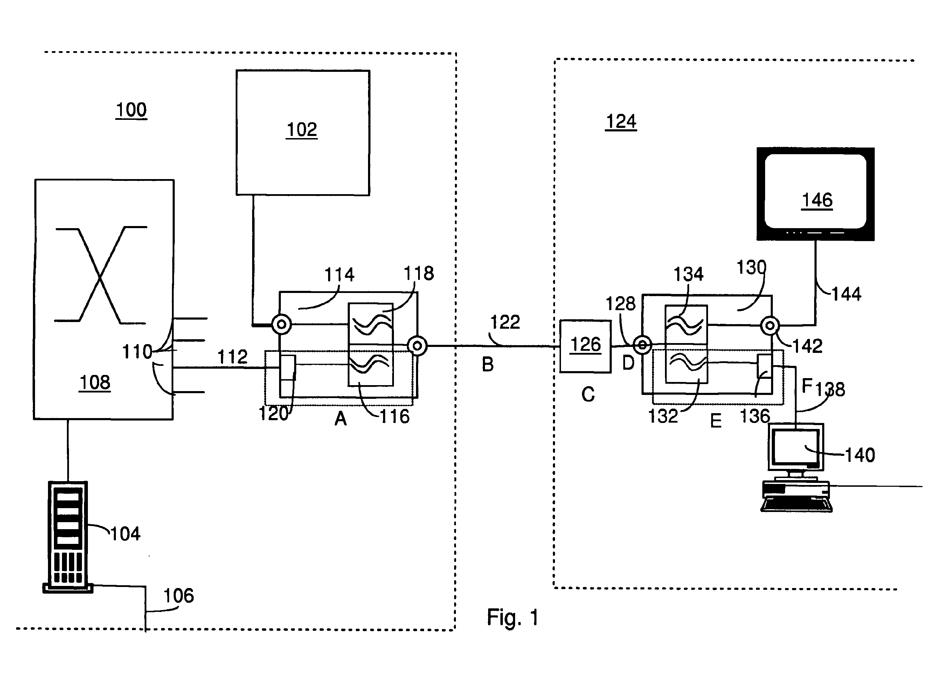

Figure 1 is a reduced block chart showing a CATV network arrangement of prior art for the transmission of a CATV signal and a baseband duplex data signal as described in patent application EP 1 099 349. The arrangement of Fig. 1 illustrates the CATV network arrangement in the substantial vicinity of home subscriber lines, where the TV signal is introduced as a broadband connection to a distribution point DP, typically via an optical fibre or a coaxial cable. From the distribution point DP on, the network is implemented as a coaxial cable network all the way to the home connection point. This coaxial cable part of the network is often called "the last 100 meters" or also "the last mile".

In Fig. 1, the distribution point 100 is shown as a single logical unit for reasons of illustration, but in practice, the components of the distribution point are separate and they may be located at relatively long distances from each other. The distribution point 100 comprises an analog and/or digital TV signal modulator 102 modulating the video and audio signal to a form suitable for the coaxial cable network. In particular, the TV signal modulator 102 may even be located at a distance of several kilometers from the other components of the distribution point. Furthermore, the network arrangement comprises a server 104 which may be located, for example, in connection with the main amplifier of the coaxial cable network, in which the Ethernet data signal is introduced via a broadband connection 106, for example a 100BaseT twin cable connection. By using suitable equipment and transmission media, the server 104 transmits the data signal further to an Ethernet switch 108 that comprises several ports 110 (so-called Ethernet multitap), with which the data signal is typically matched for a 10BaseT twin cable connection 112. For the coaxial cable network, the distribution point comprises a combiner 114 implemented primarily by means of filters (in practice, a diplexer) to filter the baseband Ethernet data signal and the CATV signal with its specific low-pass filter 116 and high-pass filter 118, respectively. These filtered signals are combined to form a combined signal to be transmitted in the coaxial cable network 122. Furthermore, in connection with the twin cable connection 120 there is a branch circuit arrangement for separating the Ethernet signals of the output and input directions for the twin cable connection 112.

In a corresponding manner, the house subscriber line 124 is provided with a ground isolator 126 to filter off the lowest interference frequencies from the combined signal. The combined signal is further led via the coaxial cable connection 128 to a wall connection 130 ("wall socket") of the home subscriber line, which comprises a separator for performing operations inverse to those of the combiner 114: a low-pass filter 132 and a high-pass filter 134 (corresponding to the filters 116 and 118) are used to separate the baseband Ethernet data signal and the CATV signal from each other. Furthermore, to separate the Ethernet signals of the input and output directions, the twin cable connector 136 used as the wall connection comprises a branch circuit arrangement similar to that in the distribution point 100. The Ethernet signal is thus input via the twin cable connector 136 and the twin cable connection 138 to the computer 140. The Ethernet signal of the reverse direction is led via the same connection in the opposite direction, respectively. Further, the CATV signal is input via the wall connector 142 and the coaxial cable 144 to the television set 146.

However, serious problems are found when the operation of such a network arrangement in the transmission of the Ethernet signal is examined in more detail. When the data signal is transmitted in the cable network, some losses always take place in the data transmission link, which are due to, for example, cable absorption, inaccurate impedance matchings, crosstalk, and coupling losses. In the Ethernet standard IEEE 802.3-2002 (paragraph 14.4.2.1), a maximum value of 11.5 dB is set for losses in one link segment at the frequency of 10 MHz. In the arrangement of Fig. 1, the link segment is formed between the Ethernet switch 108 and a home computer 140. Letters A to F in Fig. 1 indicate the factors causing substantial losses in this link segment.

The loss factor A is caused by the combination of a twin cable connector 120, a branch circuit connected to it, and a filter arrangement, wherein the total effect of all the losses is about 3.7 dB. The losses are caused primarily by the attenuation in a conventional branch circuit. The loss factor B is caused by attenuation caused by the coaxial cable 122, making up about 2.3 dB at a distance of 100 m of a typical coaxial cable. The loss factor C is due to the transducer loss in the data signal caused by the ground separator and being in the order of 0.2 dB. Also the loss factor D, which is caused by the coaxial cable having an estimated length of about 10 m, is in the order of 0.2 dB. The loss factor E is caused by a structure similar to that of the loss factor A, wherein also E equals about 3.7 dB. Finally, the loss factor F, which is caused by the twin cable having an estimated length of about 20 m, is in the order of 1.6 dB. Thus, adding up all the loss factors A to F, the total loss of the link segment is 11.7 dB, which exceeds the maximum value set in the standard for the frequency of 10 MHz.

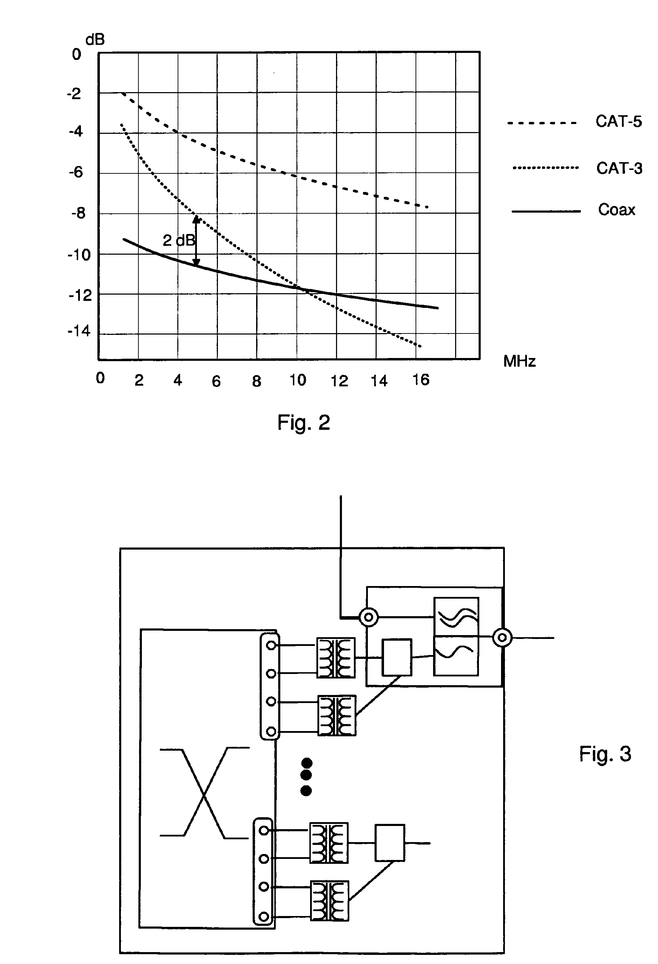

Problems occurring at lower frequencies may be illustrated by the chart of Fig. 2. The chart shows the attenuations of the Ethernet signals in the frequency domain when using, on one hand, CAT3 and CAT5 twin cables, which are commonly used in Ethernet networks, and, on the other hand, the coaxial cable (Coax) and branch circuits to be used in the above-described network arrangement. The waveform of the 10BaseT Ethernet signal is optimized in view of the twin cable transmission medium. The chart shows that the attenuation of the coaxial cable arrangement, for example at the frequency of about 5 MHz, is 2 to 3 dB more than with the CAT3 twin cable. As a result, the signal level required by the receiver for maintaining the link cannot be achieved on the whole transmission band. In other words, many computer network adapters are incapable of forming or at least continuously maintaining a data transmission link in the network structure shown in Fig. 1.

The improved CATV network arrangement according to the invention, in which the attenuation of the link segment between the Ethernet switch 108 and the home computer 140 has been reduced by about 2 dB and in which the total loss remains thus clearly below the maximum value of 11.5 dB set by the Ethernet standard IEEE 802.3-2002 is based particularly on the significant reduction of the above-described loss factor A.

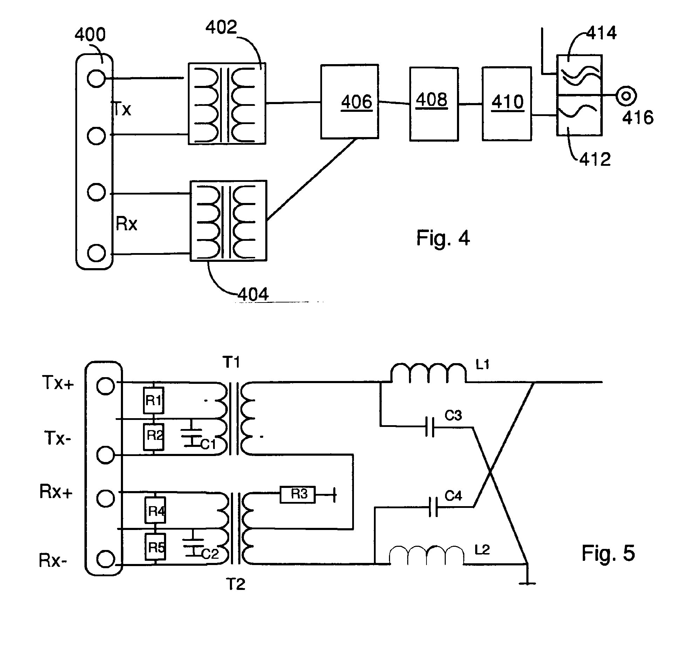

The basic idea of the invention will be illustrated in more detail by the block chart shown in Fig. 3, illustrating the structure of a distribution point according to the invention in general. One starting point of the invention is to combine the Ethernet switch (Ethernet multitap, 108 in Fig. 1) with a branch circuit and filter arrangement illustrated in more detail in Fig. 4 which, thus integrated, forms a single unit. It is thus possible to eliminate the twin cable 112 and the twin cable connector 120 of Fig. 1, and simultaneously to utilize the very high impedance of the receiving port of the Ethernet switch to produce voltage amplification. The Ethernet switch preferably comprises several, for example 10 to 15 pairs of 10BaseT or 100BaseT in/out ports, each being provided with a branch circuit and filter arrangement of Fig. 4. In Fig. 3, a diplexer is shown as part of an integrated unit, but in view of the operation of the invention, the diplexer may also be implemented as a separate filter coupled to the presented unit.

The block chart of Fig. 4 shows an asymmetric branch circuit arrangement coupled to the Ethernet switch, as well as a combiner/separator implemented by means of filters to combine/separate the baseband Ethernet data signal and the CATV signal. The branch circuit arrangement of Fig. 4 comprises an Ethernet signal to be transmitted (Tx) and an Ethernet signal to be received (Rx), which are separated for the Ethernet switch 400. Both the Ethernet signal to be transmitted and the Ethernet signal to be received are galvanically separated from the branch circuit 406 as such, by means of two transformers 402 and 404. To make the attenuation of the signal to be transmitted as low as possible, the branch circuit 406 must be designed in such a way that the transducer loss is very small, substantially about 1 dB. In the signal to be received, this causes a strong attenuation that must be compensated for.

For the compensation, the high impedance of the receiving port of the Ethernet switch can be advantageously utilized, wherein by selecting the windings of the transformer of the receiving circuit in a suitable way, it is possible to arrange sufficient voltage amplification by increasing the impedance level. The transformers 402 and 404 are preferably asymmetric with respect to their windings, and moreover, the load impedances of the receiving port and the transmission port of the Ethernet switch are unequal. Thanks to the increased impedance of the receiving branch, voltage amplification can be provided in the receiver to compensate for the attenuated signal. Thus, particularly by selecting the windings and load resistances of the receiving transformer 404 in a suitable way, the amplification of the received Ethernet signal and the impedance matchings of the branch circuit arrangement can be made significantly better than in the branch circuit arrangement of prior art, for which reason the loss caused by the branch circuit arrangement is significantly reduced.

Measurements show that by a suitable dimensioning of the components (402, 404, 406) of the branch circuit arrangement shown in Fig. 4, the part of the link segment corresponding to the loss factor A of Fig. 1 can be reduced by even more than 2 dB, that is, substantially to the value of 1.5 dB. In other words, by applying the arrangement of Fig. 4 to minimize the loss factor A in Fig. 1, the value obtained for the total loss of the link segment is about 9.5 dB at the frequency of 10 MHz. This is clearly below the maximum value of 11.5 dB set by the Ethernet standard IEEE 802.3-2002. Furthermore, the combined attenuation of the coaxial cable and the branch circuit is reduced by more than 2 dB up in the whole frequency band available, wherein for example at the frequency of about 5 MHz, the attenuation is substantially the same as for a CAT3 twin cable. Thus, in practice, all the network adapters on the market are capable of maintaining a data transmission connection with such a link segment.

Furthermore, Fig.4 shows, in one embodiment, a group delay equalizer 408 coupled to the branch circuit arrangement, for the purpose of correcting the group delay caused by filtering in the Ethernet signal. Moreover, the group delay pattern of a twin cable differs from the group delay caused by a coaxial cable. In general, the reception of a 10BaseT Ethernet signal is designed in view of distortions caused by a twin cable, so that the above-mentioned group delays causing nonlinearity of the channel must be corrected. The group delay equalizer 408 may be preferably implemented as a simple group delay equalizer of type 1, which only comprises passive LC components.

Furthermore, Fig. 4 shows overvoltage protection 410 to protect the components of the branch circuit from surge waves. Separate overvoltage protection is necessary, because the low frequency for filtering the Ethernet signal is about 100 kHz, wherein, for example, surge waves caused by lightning have relatively free access to the high impedances of the branch circuit and the transformers. Thus, damaging of the components is probable, if no separate overvoltage protection is used. It must, of course, be noticed that the presented group delay equalizer and overvoltage protection are not essential for reducing the attenuation and thereby for the implementation of the invention, but they improve, for their part, the reliability of the link segment.

Furthermore, Fig. 4 shows the filters (diplexer) of Fig. 1 for filtering the baseband Ethernet data signal with a specific low-pass filter 412 and for filtering the CATV signal with a specific high-pass filter 414, respectively. A combined signal 416 is formed of these filtered signals to be transmitted in the coaxial cable network. Naturally, when receiving the combined signal, the respective filters separate the baseband Ethernet data signal and the CATV signal from the combined signal.

Figure 5 shows a switch diagram for implementing the branch circuit and the group delay equalizer according to one embodiment of the invention. The Ethernet switch comprises ports for both the signal to be transmitted (Tx) and the signal to be received (Rx). In practice, the transmitting Ethernet port is used as a pull-down current controller, which inputs the signal to the coaxial cable instead of a typical 100-ohm twin cable. In this coupling, the transformation ratio of the transformer T1 is selected so that the signal amplitudes are the same as in the twin cable application, but the network load impedance is lower. The outgoing signal is input via the transformer T1 to the middle point of the primary windings of the transformer T2, wherein the current is divided in half in the direction of the coaxial cable and in half in the direction of a terminal resistor R3. The directivity of the coupling is a result of the fact that the currents entering the different branches are different in direction and equal in magnitude in view of the magnetic field, wherein no transmission signal is coupled to the receiving port of the Ethernet switch. The dimension of the resistance R3 should correspond to the impedance of the coaxial cable, wherein the balance of the transformer is at its best and its directivity is at its maximum.

In the reception of the Ethernet signal, the signal passes through the primary windings of the transformer T2 to the terminal resistor R3. The resistors R4 and R5 are reflected on the primary side as low impedances according to the transformation ratio, wherein the terminal impedance of the coaxial cable is higher than the nominal impedance. The resistors R1 and R2 of the transmission port reduce the terminal impedance, wherein the matching of the coaxial cable is improved. The current of the primary side is reflected on the secondary side of the transformer T2. The secondary side is loaded with high impedances R4 and R5, wherein the received voltage increases by a change in the impedance level. The ratio of the transformation determines the change in the voltage amplification and the impedance level. By suitable dimensioning, the attenuation of a directional switch can be almost compensated for in the receiving branch by voltage amplification.

In the example of Fig. 5, the group delay equalizer is implemented in a simple manner by two cross-coupled LC circuits that comprise a coil L1 and a capacitor C3, and a coil L2 and a capacitor C4, respectively. The LC circuits are coupled to the transmitting and receiving branches of the branch circuit and further as a combined Ethernet signal towards the overvoltage protection. It should be noted that the above-presented coupling is only an example of the implementation of an asymmetric branch circuit and a group delay equalizer according to the invention. It will be obvious for a person skilled in the art that the same effect can be achieved by a variety of coupling and component alternatives.

The amplification of the received Ethernet signal is adjusted by a suitable selection of the windings and the resistors in the receiving transformer so that the link budget can be fitted within the limits set by the standard and, at the same time, to be sufficiently low for the network adapters to operate across the link. In this respect, the adjustment must be made at a relatively high accuracy, because too high an amplification causes crosstalk between the transmitted and received signals and thereby coupling of the signal power with losses. On the other hand, too low an amplification is not sufficient for fitting the link budget within the desired limits.

Above all, the selection and adjustments of the components are affected by the Ethernet switch used, and the impedance of its receiving port, with respect to which the other components must be dimensioned. One example to be presented is Marwell SOHO Ethernet multi-port switch 88E6063, in which the impedance of the receiving port is several kiloohms and the control voltage in both ports (Tx, Rx) is 2.5 V. The drive current of the transmission port is 100 mA. Thus, the above-presented components can be dimensioned, for example, as follows: the resistances R1, R2 are 680 ohm and the capacitor C1 is 4.7 µF, the terminal resistance R3 is 75 ohm, the resistances R4, R5 are 330 ohm, and the capacitor C2 is 100 nF. The transmission ratio of the windings is about 1:1.8 of the transmission transformer and about 15:1 in the receiving transformer. For example, with such a coupling, the achieved transducer loss of the signal to be transmitted is about 1.5 dB at the branch circuit. In a corresponding manner, the signal to be received is subjected to a strong attenuation of about 10.5 dB, which is, in turn, almost fully compensated for by an amplification of about 9 dB provided by means of the transformer of the receiving circuit and the impedance of the receiving port. Thus, for the presented branch circuit, the remaining signal attenuation is about 1.5 dB, which is an improvement of about 2 dB in the link budget in both directions. When using another Ethernet switch, the components must be dimensioned to be suitable for the values of the switch in question, which can be easily implemented by a person skilled in the art.

It will be obvious for a person skilled in the art that with technological developments, the basic idea of the invention can be implemented in a variety of ways. Thus, the invention and its embodiments are not limited to the above-described examples but they may vary within the scope of the claims.

## Claims

1. A communication system for transmitting a cable television signal and baseband duplex data signal as a combined signal in a coaxial cable network, the communication system comprising
a television signal modulator (102) for forming a cable television signal;
a data network node point (108) for transmitting the baseband data signal between said communication system and an external data network (106) or a server (104);
a combiner (114) for filtering the cable television signal and the baseband data signal to separate frequencies and for combining them into a combined signal to be transmitted in a coaxial data network (122);
a separator (130) for filtering the cable television signal and the baseband data signal from the received combined signal to their separate frequencies and for separating them into separate signals;
connector means (136) for transmitting said separated baseband data signal further to at least one terminal (140), **characterized in that**
said node point (108, 400) of the data network comprises a high impedance receiving port (110, Rx) for receiving a data signal from at least one terminal (140) via said coaxial cable network (122), and that the communication system comprises
an asymmetric branch circuit (406) coupled in an integrated manner between at least said data network node point (108, 400) and said combiner (114; 412, 414), for separating the data signal to be transmitted and the data signal to be received into branches (Tx, Rx) of their own for said connecting point, in which branch circuit
the impedances of said branches (Tx, Rx) are arranged to be substantially unequal in such a way that the impedance of the receiving branch (Rx) is arranged to be higher, consisting substantially of the impedance of said receiving port at said node point, and
which receiving branch (Rx) is provided with a voltage amplification by means of a transformer coupling (404, T2) in the receiving branch and the impedance of said receiving branch, to compensate for the attenuation in the receiving branch.

2. The communication system according to claim 1, **characterized in that**
said baseband duplex data signal is a signal according to the Ethemet standard.

3. The communication system according to claim 1 or 2, **characterized in that**
said asymmetric branch circuit (406) is provided with a group delay equalizer (408) to compensate for group delays of said data signal between said data network (106) and said cable network (122).

4. A network element in a communication network, the network element comprising
first connector means (114) for receiving a cable television signal;
second connector means (120) for receiving a baseband data signal;
filter means (116, 118) for filtering a cable television signal to be transmitted and a baseband data signal to be transmitted, to separate frequencies and for combining them into a combined signal to be transmitted via third connector means (416) in a coaxial cable network (122), and for filtering a baseband data signal to be received via said third connector means (416) to its specific frequency and for filtering it into a separate signal, **characterized in that** the network element comprises
an integrated node point (108, 400) of the data network for transmitting the baseband data signal via said communication network and an external data network (106) or a server (104), the node point comprising a high impedance receiving port (110, Rx) for receiving a data signal from at least one terminal (140); and
an asymmetric branch circuit (406) coupled in an integrated manner between said node point (400) of the data network and said filter means (116, 118; 412, 414), for separating the data signal to be transmitted and the data signal to be received into branches (Tx, Rx) of their own, in which branch circuit
the impedances of said branches (Tx, Rx) are arranged to be substantially unequal in such a way that the impedance of the receiving branch is arranged to be higher, consisting substantially of the impedance of said receiving port at said node point; and
which receiving branch is provided with a voltage amplification by means of a transformer coupling (404, T2) in the receiving branch and the impedance of said receiving branch, to compensate for the attenuation in the receiving branch.

5. The network element according to claim 4, **c h a r a c t e r i z e d** in that
said node point (400) of the data network comprises an Ethernet switch, in which said branch circuit is integrated as a single unit.

6. The network element according to claim 4 or 5, **characterized in that**
said asymmetric branch circuit (406) is provided with a group delay equalizer (408) to compensate for group delays of said data signal between said coaxial cable network (122) and the external data network (106).

7. An asymmetric branch circuit (406) for a communication system, in which communication system a cable television signal and a baseband duplex data signal are transmitted as a combined signal in a coaxial cable network (122), **characterized in that**
the asymmetric branch circuit (406) is coupled in an integrated manner between a node point (108, 400) of a data network comprising a high impedance receiving point (110, Rx) and a combiner (114; 412, 414) combining a cable television signal and a baseband duplex data signal, to separate the data signal to be transmitted and the data signal to be received, into separate branches (Tx, Rx) for said node point, in which asymmetric branch circuit (406)
the impedances of said branches (Tx, Rx) are arranged to be substantially unequal in such a way that the impedance of the receiving branch is arranged to be higher, consisting substantially of the impedance of said receiving port at said node point; and
which receiving branch is provided with a voltage amplification by means of a transformer coupling (404, T2) in the receiving branch and the impedance of said receiving branch, to compensate for the attenuation in the receiving branch.

8. The asymmetric branch circuit according to claim 7, **characterized in that**
said baseband duplex data signal is a signal according to the Ethernet standard.

9. The asymmetric branch circuit according to claim 8, **characterized in that**
the transmission branch (Tx) comprises a transformer (T1) whose transmission ratio is arranged so that the amplitude of the data signal to be transmitted corresponds substantially to the amplitude of the Ethernet signal to be input in the twin cable.

## Patentansprüche

1. Ein Kommunikationssystem zum Übermitteln eines Kabel-TV-Signals und eines Duplex-Basisbanddatensignals als ein gemeinsames Signal in einem Koaxialkabelnetzwerk, das Kommunikationssystem weist auf:
- ein TV-Signal Modulator (102) zum Bilden eines Kabel-TV-Signals;
- ein Datennetzwerk-Knotenpunkt (108) zum Übermitteln des Basisbanddatensignals zwischen dem Kommunikationssystems und einem externen Datennetzwerk (106) oder einem Server (104);
- ein Kombinator (114) zum Filtern des Kabel-TV-Signals und das Basisbanddatensignal in getrennte Frequenzen und zum Zusammenfassen dieser in ein gemeinsames Signal, um in einem Koaxialkabelnetzwerk (122) übertragen zu werden;
- eine Trennvorrichtung (130) zum Filtern des Kabel-TV-Signals und des Basisbanddatensignals aus dem empfangenen gemeinsamen Signal in ihre einzelnen Frequenzen und zum Trennen dieser in getrennte Signale;
- Verbindungsmittel (136) zum Übermitteln des separaten Basisbanddatasignal weiterhin zu mindestens einem Terminal (140), **dadurch gekennzeichnet, dass**
- der Knotenpunkt (108, 400) des Datennetzwerkes einen Hochimpedanz-Empfangsport (110, Rx) zum Empfangen eines Datensignals von mindestens einem Terminal (140) über das Koaxialkabelnetzwerk (122) aufweist, und wobei das Kommunikationssystem aufweist
- eine asymmetrische Abzweigungsschaltung (406) gekoppelt in einer integrierten Art und Weise zwischen dem mindestens einen Datennetzwerk-Knotenpunkt (108, 400) und dem Kombinator (114, 412, 414) zum Trennen des zu übertragenden Datensignals und des zu empfangenden Datensignals in eigene Zweige (Tx, Rx) für den Verbindungspunkt, wobei in der Abzweigungsschaltung
- die Impedanzen der Zweige (Tx, Rx) im Wesentlichen derart ungleich eingerichtet sind, dass die Impedanz des empfangenden Zweiges (Rx) höher ausgebildet ist, bestehend im Wesentlichen aus der Impedanz des Empfangsports an dem Knotenpunkt, und
- der empfangende Zweig (Rx) mit einem Spannungsverstärker ausgestattet ist, der durch eine Transformatorkoppelung (404, T2) in dem empfangenden Zweig und der Impedanz des empfangenden Zweiges gebildet ist, um die Dämpfung in dem empfangenden Zweig zu kompensieren.

2. Das Kommunikationssystem nach Anspruch 1, **dadurch gekennzeichnet, dass** das Duplex-Basisbanddatensignal ein Einzelnes bezüglich des Ethernet Standards ist.

3. Das Kommunikationssystem nach Anspruch 1 oder 2, **dadurch gekennzeichnet, dass** die asymmetrische Abzweigungsschaltung (406) mit einem Gruppenlaufzeitentzerrer (408) ausgestattet ist, um Gruppenlaufzeiten des Datensignals zwischen dem Datennetzwerk (106) und dem Kabelnetzwerk (122) zu kompensieren.

4. Ein Netzwerkelement in einem Kommunikationssystem, das Netzwerkelement weist auf
- erste Verbindungsmittel (114) zum Empfangen eines Kabel-TV-Signals;
- zweite Verbindungsmittel (120) zum Empfangen eines Basisbanddatensignals;
- Filtermittel (116, 118) zum Filtern eines zu übertragenden Kabel-TV-Signals und eines zu übertragenden Basisbanddatensignal in getrennte Frequenzen und zum Zusammenfassen dieser in ein gemeinsames Signal, um über dritte Verbindungsmittel (416) in einem Koaxialkabelnetzwerk (122) übertragen zu werden, und zum Filtern eines über die dritten Verbindungsmittel (416) zu empfangenden Basisbanddatensignals in seine spezifischen Frequenzen und zum Filtern in ein getrenntes Signal, **dadurch gekennzeichnet, dass** das Netzwerkelement aufweist
- einen integrierten Knotenpunkt (108, 400) des Datennetzwerkes zum Übertragen des Basisbanddatensignals über das Kommunikationsnetzwerk und einem externen Datennetzwerk (106) oder einem Server (104), der Knotenpunkt weist einen Hochimpedanz-Empfangsport (110, Rx) zum Empfangen eines Datensignals von mindestens einem Terminal (140) auf; und
- eine asymmetrische Abzweigungsschaltung (406) gekoppelt in einer integrierten Art und Weise zwischen dem mindestens einen Knotenpunkt (400) des Datennetzwerkes und den Filtermitteln (116, 118, 412, 414) zum Trennen des zu übertragenden Datensignals und des zu empfangenden Datensignals in eigene Zweige (Tx, Rx), wobei in der Abzweigungsschaltung
- die Impedanzen der Zweige (Tx, Rx) im Wesentlichen derart ungleich eingerichtet sind, dass die Impedanz des empfangenden Zweiges höher ausgebildet ist, bestehend im Wesentlichen aus der Impedanz des Empfangsports an dem Knotenpunkt, und
- der empfangende Zweig mit einem Spannungsverstärker ausgestattet ist, der durch eine Transformatorkoppelung (404, T2) in dem empfangenden Zweig und der Impedanz des empfangenden Zweiges gebildet ist, um die Dämpfung in dem empfangenden Zweig zu kompensieren.

5. Das Netzwerkelement nach Anspruch 4, **dadurch gekennzeichnet, dass** der Knotenpunkt (400) des Datennetzwerkes einen Ethernet-Switch aufweist, in dem die Abzweigungsschaltung als eine einzelne Einheit integriert ist.

6. Das Netzwerkelement nach Anspruch 4 oder 5, **dadurch gekennzeichnet, dass** die asymmetrische Abzweigungsschaltung (406) mit einem Gruppenlaufzeitentzerrer (408) ausgestattet ist, um Gruppenlaufzeiten des Datensignals zwischen dem Datennetzwerk (106) und dem Kabelnetzwerk (122) zu Kompensieren

7. Eine asymmetrische Abzweigungsschaltung (406) für ein Kommunikationssystem, in dem das Kommunikationssystem ein Kabel-TV-Signal und ein Duplex-Basisbanddatensignal als ein gemeinsames Signal in einem Koaxialkabelnetzwerk (122) überträgt, **dadurch gekennzeichnet, dass**
- die asymmetrische Abzweigungsschaltung (406) gekoppelt ist in einer integrierten Art und Weise zwischen einem Knotenpunkt (108, 400) eines Datennetzwerkes aufweisend einen Hochimpedanz-Empfangspunkt (110, Rx) und einem Kombinator (114; 412, 414), der ein Kabel-TV-Signal und ein Duplex-Basisbanddatensignal zusammenfasst, zum Trennen des zu übertragenden Datensignals und des zu empfangenden Datensignals in eigene Zweige (Tx, Rx) für den Knotenpunkt, wobei in der asymmetrischen Abzweigungsschaltung (406)
- die Impedanzen der Zweige (Tx, Rx) im Wesentlichen derart ungleich eingerichtet sind, dass die Impedanz des empfangenden Zweiges höher ausgebildet ist, bestehend im Wesentlichen aus der Impedanz des Empfangsports an dem Knotenpunkt, und
- wobei der empfangende Zweig mit einem Spannungsverstärker ausgestattet ist, der durch eine Transformatorkoppelung (404, T2) in dem empfangenden Zweig und der Impedanz des empfangenden Zweiges gebildet ist, um die Dämpfung in dem empfangenden Zweig zu kompensieren.

8. Die asymmetrische Abzweigungsschaltung nach Anspruch 7, **dadurch gekennzeichnet, dass** das Duplex-Basisbanddatensignal ein Einzelnes bezüglich des Ethernet Standards ist.

9. Die asymmetrische Abzweigungsschaltung nach Anspruch 8, **dadurch gekennzeichnet, dass** der übertragende Zweig (Tx) einen Transformer (T1) aufweist, dessen Übertragungsverhältnis so eingerichtet ist, das die Amplitude des zu übertragenden Datensignals im Wesentlichen mit der Amplitude des in das Zwillingskabel eingegebenen Ethernet Signals korrespondiert.

## Revendications

1. Un système de communication pour la transmission d'un signal de télévision par câble et d'un signal de données duplex de bande de base sous la forme d'un signal combiné dans un réseau à câble coaxial, le système de communication comprenant
un modulateur de signal de télévision (102) destiné à former un signal de télévision par câble,
un point nodal de réseau de données (108) destiné à la transmission du signal de données de bande de base entre ledit système de communication et un réseau de données externe (106) ou un serveur (104),
un combineur (114) destiné à filtrer le signal de télévision par câble et le signal de données de bande de base de façon à séparer des fréquences et à les combiner en un signal combiné à transmettre dans un réseau de données coaxial (122),
un séparateur (130) destiné à filtrer le signal de télévision par câble et le signal de données de bande de base à partir du signal combiné reçu vers leurs fréquences distinctes et à les séparer en signaux distincts,
un moyen de connexion (136) destiné à la transmission dudit signal de données de bande de base séparé vers au moins un terminal (140), **caractérisé en ce que**
ledit point nodal (108, 400) du réseau de données comprend un port de réception à haute impédance (110, Rx) destiné à la réception d'un signal de données provenant d'au moins un terminal (140) par l'intermédiaire dudit réseau à câble coaxial (122), et **en ce que** le système de communication comprend
un circuit de dérivation asymétrique (406) couplé de manière intégrée entre au moins ledit point nodal de réseau de données (108, 400) et ledit combineur (114, 412, 414), de façon à séparer le signal de données à transmettre et le signal de données à recevoir en dérivations (Tx, Rx) propres pour ledit point de connexion, où dans ledit circuit de dérivation
les impédances desdites dérivations (Tx, Rx) sont agencées de façon à être sensiblement inégales de sorte que l'impédance de la dérivation de réception (Rx) soit agencée de façon à être plus élevée, se composant sensiblement de l'impédance dudit port de réception au niveau dudit point nodal, et
ladite dérivation de réception (Rx) est équipée d'une amplification de tension au moyen d'un couplage par transformateur (404, T2) dans la dérivation de réception et l'impédance de ladite dérivation de réception de façon à compenser l'atténuation dans la dérivation de réception.

2. Le système de communication selon la revendication 1, **caractérisé en ce que**
ledit signal de données duplex de bande de base est un signal conforme à la norme Ethernet.

3. Le système de communication selon la revendication 1 ou 2, **caractérisé en ce que**
ledit circuit de dérivation asymétrique (406) est équipé d'un égaliseur de retard de groupe (408) destiné à compenser des retards de groupe dudit signal de données entre ledit réseau de données (106) et ledit réseau câblé (122).

4. Un élément de réseau dans un réseau de communication, l'élément de réseau comprenant
un premier moyen de connexion (114) destiné à la réception d'un signal de télévision par câble,
un deuxième moyen de connexion (120) destiné à la réception d'un signal de données de bande de base,
un moyen de filtrage (116, 118) destiné à filtrer un signal de télévision par câble à transmettre et un signal de données de bande de base à transmettre, à séparer des fréquences et à les combiner en un signal combiné à transmettre par l'intermédiaire d'un troisième moyen de connexion (416) dans un réseau à câble coaxial (122), et à filtrer un signal de données de bande de base à recevoir par l'intermédiaire dudit troisième moyen de connexion (416) vers sa fréquence spécifique et à le filtrer en un signal distinct, **caractérisé en ce que** l'élément de réseau comprend
un point nodal intégré (108, 400) du réseau de données destiné à la transmission du signal de données de bande de base par l'intermédiaire dudit réseau de communication et d'un réseau de données externe (106) ou d'un serveur (104), le point nodal comprenant un port de réception à haute impédance (110, Rx) destiné à la réception d'un signal de données provenant d'au moins un terminal (140), et
un circuit de dérivation asymétrique (406) couplé de manière intégrée entre ledit point nodal (400) du réseau de données et ledit moyen de filtrage (116, 118, 412, 414), de façon à séparer le signal de données à transmettre et le signal de données à recevoir en dérivations (Tx, Rx) propres, où dans ledit circuit de dérivation
les impédances desdites dérivations (Tx, Rx) sont agencées de façon à être sensiblement inégales de sorte que l'impédance de la dérivation de réception soit agencée de façon à être plus élevée, se composant sensiblement de l'impédance dudit port de réception au niveau dudit point nodal, et
ladite dérivation de réception est équipée d'une amplification de tension au moyen d'un couplage par transformateur (404, T2) dans la dérivation de réception et l'impédance de ladite dérivation de réception de façon à compenser l'atténuation dans la dérivation de réception.

5. L'élément de réseau selon la revendication 4, **caractérisé en ce que**
ledit point nodal (400) du réseau de données comprend un commutateur Ethernet, dans lequel ledit circuit de dérivation est intégré sous la forme d'une unité unique.

6. L'élément de réseau selon la revendication 4 ou 5, **caractérisé en ce que**
ledit circuit de dérivation asymétrique (406) est équipé d'un égaliseur de retard de groupe (408) destiné à compenser des retards de groupe dudit signal de données entre ledit réseau à câble coaxial (122) et le réseau de données externe (106).

7. Un circuit de dérivation asymétrique (406) pour un système de communication, où dans ledit système de communication un signal de télévision par câble et un signal de données duplex de bande de base sont transmis sous la forme d'un signal combiné dans un réseau à câble coaxial (122), **caractérisé en ce que**
le circuit de dérivation asymétrique (406) est couplé de manière intégrée entre un point nodal (108, 400) d'un réseau de données comprenant un point de réception à haute impédance (110, Rx) et un combineur (114, 412, 414) combinant un signal de télévision par câble et un signal de données duplex de bande de base, de façon à séparer le signal de données à transmettre et le signal de données à recevoir, en dérivations distinctes (Tx, Rx) pour ledit point nodal, où dans ledit circuit de dérivation asymétrique (406),
les impédances desdites dérivations (Tx, Rx) sont agencées de façon à être sensiblement inégales de sorte que l'impédance de la dérivation de réception soit agencée de façon à être plus élevée, se composant sensiblement de l'impédance dudit port de réception au niveau dudit point nodal, et
ladite dérivation de réception est équipée d'une amplification de tension au moyen d'un couplage par transformateur (404, T2) dans la dérivation de réception et l'impédance de ladite dérivation de réception de façon à compenser l'atténuation dans la dérivation de réception.

8. Le circuit de dérivation asymétrique selon la revendication 7, **caractérisé en ce que**
ledit signal de données duplex de bande de base est un signal conforme à la norme Ethernet.

9. Le circuit de dérivation asymétrique selon la revendication 8, **caractérisé en ce que**
la dérivation de transmission (Tx) comprend un transformateur (T1) dont le rapport de transmission est agencé de sorte que l'amplitude du signal de données à transmettre corresponde sensiblement à l'amplitude du signal Ethernet à entrer dans le câble jumelé.
